# EUROPEAN PATENT SPECIFICATION

(11) **EP 0 388 343 B1**
(45) Date of publication and mention of the grant of the patent: **17.07.1996**
(21) Application number: 90480016.6
(22) Date of filing: 02.02.1990
(51) Int. Cl.: G03F 7/039

(54) **Chemically amplified photoresist**
Chemisch amplifizierter Photolack
Photoréserve avec amplification chimique

(30) Priority: 14.03.1989 US 322848
(43) Date of publication of application: 19.09.1990
(73) Proprietor: International Business Machines Corporation, Armonk, N.Y. 10504 (US)
(72) Inventor: Brunsvold, William Ross, Poughkeepsie, N.Y. 12603 (US); Knors, Christopher John, Wappingers Falls, N.Y. 12590 (US); Kwong, Ranee Wai-Ling, Wappingers Falls, N.Y. 12590 (US); Miura, Steve Seiichi, Poughkeepsie, N.Y. 12601 (US); Montgomery, Melvin Warren, New Windsor, N.Y. 12550 (US); Moreau, Wayne Martin, Wappingers Falls, N.Y. 12590 (US); Sachdev, Harbans Singh, Wappingers Falls, N.Y. 12590 (US)
(74) Representative: Klein, Daniel Jacques Henri

(56) References cited:
- EP-A- 0 102 450
- US-A- 3 782 939
- US-A- 4 371 605
- IBM TECHNICAL DISCLOSURE BULLETIN. vol. 18, no. 6, 06 November 1975, NEW YORK US, HAMEL C.J. & KRISTOFF J.S: "PHOTORESIST ADDITIVE SENSITIZER"

## Description

The present invention relates to lithographic resists or photoresists which have increased sensitivity and which are free of metallic sensitizers. In particular, it relates to resists which achieve chemical amplification by means of sulfonyloxyimide sensitizers which generate a strong acid upon exposure to ultraviolet, electron beam or x-ray radiation.

The fabrication of semiconductor devices requires the use of resist compositions which can be imaged and transfer image patterns during processing. As the need to increase semiconductor circuit density has dictated, a movement from very large-scale integration (VLSI) devices to ultra-large scale integration (ULSI) devices, the demand for materials useful in submicron photolithography which are capable of producing and maintaining ultra-fine tolerances has become critical. To achieve such tolerances, chemically amplified resist systems comprising a polymeric material and an acid generating sensitizer, have been developed in order to take advantage of the increased sensitivity of tools using the ultraviolet, electron beam and x-ray radiation spectra. The terms resist, lithographic resist and photoresist are used interchangeably. Films of these materials may be imaged with different radiation wavelengths or modes to provide patterns having resistance to dry or wet processing as is known in the art.

US-A-4 102 687 discloses UV curable organic resin compositions comprising a thermosetting organic condensation resin of formaldehyde with urea, phenol or melamine and a Group VIa (i.e., S, Se or Te) onium salt. The use of such compositions as photoresists is suggested.

US-A-4 108 747 discloses the use of polyaryloniumtrifluoromethanesulfonate salts as photoinitiators for a variety of cationically polymerizable organic materials. The disclosed ionic onium triflate salts were shown to be useful in imagable photoresists where negative images were formed by a mechanism which cross-linked a epoxy novolak resins.

US-A-4 371 605 discloses the use of sulfonic acid esters of N-hydroxyamides and N-hydroxyimides as photoinitiators for certain photopolymerizable compositions. Polyaromatic sensitizers were added to enhance the sensitivity of the composition, but these sensitizers are too opaque at 254 nm to be useful for deep UV applications. The presumed mechanism for such photoinitiation, involves a cleavage of the photoinitiator upon irradiation to produce the corresponding sulfonic acid which in turn catalyzes the cationic polymerization of the polymerizable substance. The polymerizable materials include ethylenically unsaturated compositions, ring compositions that undergo a ring opening, and like acid catalyzed polymerizable materials (e.g., melamine resins).

US-A-4 603 101 discloses photoresist compositions comprising cationic photoinitiators such as diaryliodonium salts and aryl sulfonium salts and a polystyrene made from t-substituted organomethyl vinylary lethers. There are disclosed method to make the system more sensitive to longer wavelengths.

Umehara, et al, "Application of Silicon Polymer as Positive Photo Sensitive Material" (Society of Plastic Engineers, Mid-Hudson Section, Technical Papers: Photo Polymers--Processes and Materials, pages 122-131, (1988) discloses the use of positive working compositions comprising silyl ethers containing polymers which exhibit improved hydrophilicity and tri-halomethyl substituted s-triazine and 1,3,4-oxadiazole photo-induced acid precursors. The use of an N-phenylsulfonyloxy-1,8-naphthalimide sensitizer is shown, but the performance is said to be poorer than quinone diazide -- the standard or control.

US-A-4 491 628 discloses resists sensitive to UV, electron beam and X-ray radiation with positive or negative tone upon proper choice of a developer are formulated from a polymer having recurrent pendant groups such as tert-butyl ester or tert-butyl carbonates that undergo efficient acidolysis with concomitant changes in polarity (solubility) together with a photoinitiator which generates acid upon radiolysis.

A difficulty with onium salt sensitizers has been the lack of compatibility with many resist polymers because of polarity differences and limited solubility in many organic solvents, especially non-polar or moderately polar solvents. Although onium salts with metal ions such as Ph₃SSbF₆ have high purity, high thermal stability, and provide very sensitive resist systems, the need for a non-metallic sensitizer in semiconductor processing exists due to the necessity of avoiding formation of insoluble and nonvolatile metal oxides during reactive ion-etching and of preventing metal contamination during ion-implant.

The use of photolithography in the manufacture of integrated semiconductor circuits is conventional. However, a more sensitive resist system which can be developed more rapidly greatly effects manufacturing yield and cost.

According to IBM Technical Disclosure Bulletin Vol. 18 No. 6, Nov. 1975 p 1775, photoresist addive sensitizer, to achieve a more sensitive photoresist system, it is believed necessary to chemically modify the resist compound structure or add to an existing resist a speed additive, which will decrease development time and not degrate image quality. It was found that AZ 1350J (R) is enhanced by the addition of hydroquinone, C₆H₄(OH)₂. This additive molecule acts in such a fashion that development time is substantially reduced in optical exposures, without any loss in quality.

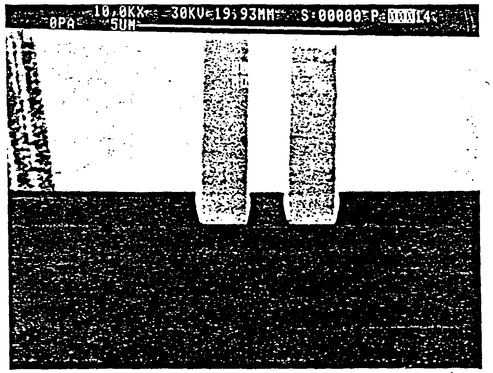

The Figure is a photomicrograph showing imaged photoresist having 1 µm lines and spaces and nearly vertical profiles.

### SUMMARY OF INVENTION

In accordance with the present invention, resists for use in ultra-violet, electron beam and x-ray exposure devices are provided which comprise a polymeric or molecular composition, the solubility of the composition being dependent upon the presence of acid removable protecting groups, and a sulfonic acid precursor which generates a strong acid upon exposure to such radiation. The sulfonic acid precursor is an N-sulfonyloxyimide of the form 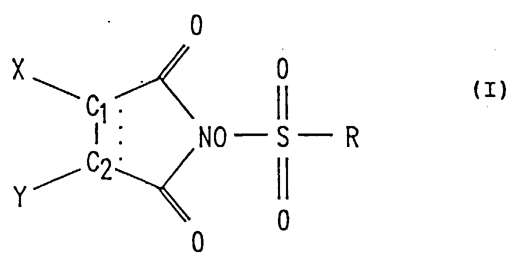 wherein R is selected from the group consisting of -CF₃, -CF₂CF₃, -CF₂CF₂H, -(CF₂)-Zₙ where n=1 to 4, where Z is H, alkyl or aryl, 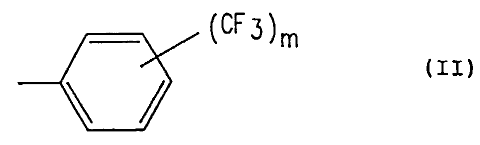 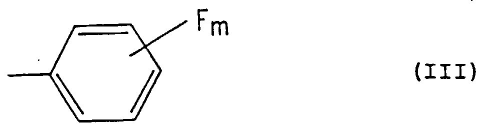 where m is from 1 to 5, and where X and Y (1) form a cyclic or polycyclic ring which may contain one or more hetero atoms, (2) form a fused aromatic ring, (3) may be independently H, alkyl or aryl, (4) may be attached to another sulfonyoxyimide containing residue, or (5) may be attached to a polymeric chain or backbone. It has been found that the sulfonyloxyimide sensitizers of the present invention provide increased sensitivity when used in a variety of photoresist compositions which may be exposed under various radiation conditions. The resist formulations of the present invention comprise an N-fluoroalkylsulfonyloxyimide sensitizer and a polymeric resin or molecular monomer having an acid removable protecting group such as a carbonate or a carboxylate. Many such resins and monomers which can be protected are well known in the art. They include, for example, novolak resins such as cresolnovolak, p-hydroxystyrene and copolymers of methacrylic acids and esters thereof as well as their momeric precursors. The sulfonyloxyimide sensitizer is used in admixture with the resin or is attached to the polymer backbone, and is present in a quantity such that upon exposure of the resist to ultraviolet radiation, electron beam radiation or x-ray beam radiation the composition becomes more soluble when working in a positive tone and less soluble when working in a negative tone. In general, the sulfonyloxyimide sensitizer is present in from about 1 to 20% by weight of the resin. It is preferred that such sulfonic acid precursor be present in an amount of 5 to 10% by weight based upon the resin. The resist formulations may contain additives which enhance the sensitivity of the formulation including plasticizers, surfactants, adhesion promotors, casting solvents, dyes, preservatives, etc., and may be made positive or negative working as will become apparent to those skilled in the art.

In order that those skilled in the art will be better able to practice the invention, the following examples are given by way of illustration and not by way of limitation. All parts and percentages given herein are by weight.

### Example 1:

Monofunctional trifluoromethylsulfonyloxy dicarboximides (or dicarboximide triflates) were prepared by a method similar to that set forth by Beard et al, J. Org. Chem., 38, 3673 (1973). Addition of one 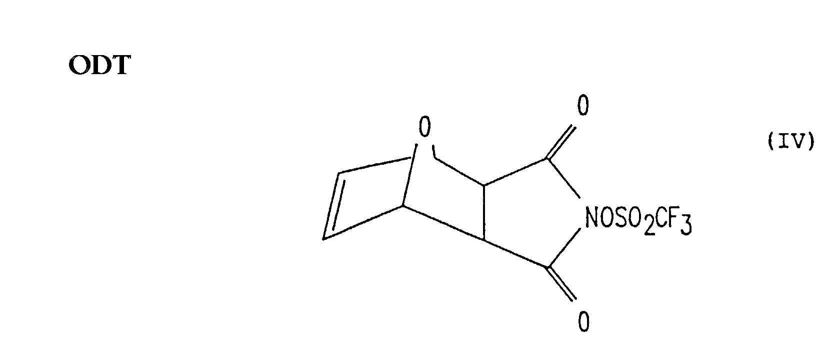 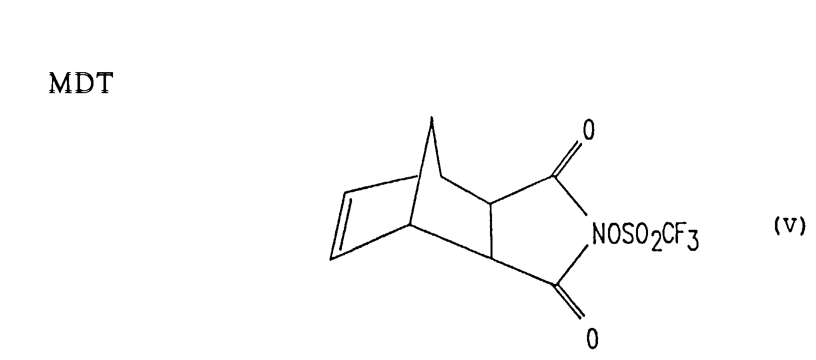 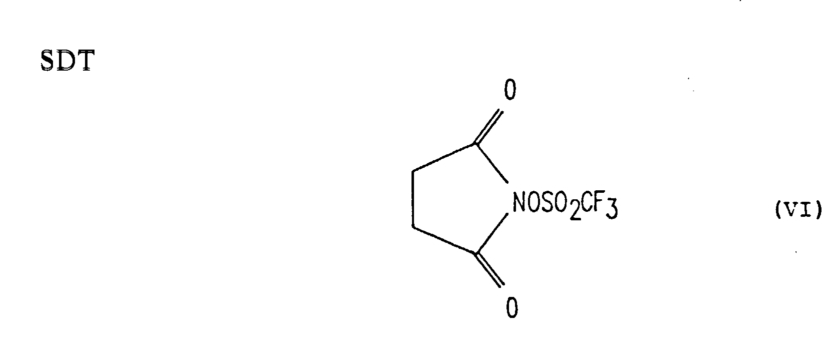 equivalent of pyridine to an equimolar mixture of N-hydroxydicarboximide and trifluoromethane sulfonic anhydride in methylene chloride at 0 to 10°C gave moderate to high yields as shown in Table 1.

**Table 1**

| Product | Yield | Melting Point |
|---|---|---|
| ODT | 30% | 113-115°C |
| MDT | 90% | 88-90°C |
| SDT | 76% | 124-126°C |

### Example 2:

A photoresist formulation comprising about 20 weight percent poly(4-t-butyloxycarbonyloxystyrene) (PBOCST) prepared in accordance with U.S. Patent No. 4,491,628, 4 weight percent of trifluoromethylsulfonyloxy-7-oxabicyclo[2.2.1]hept-5-ene -2,3-dicarboximide made in accordance with the procedure of Example 1 and referred to as ODT and 76 weight percent of propylene glycol methyl ether acetate was coated onto a silicon wafer and baked for 1 minute on a 100°C hot plate to give a 1.1 µm film. The coated wafer was exposed to deep ultraviolet radiation through a chrome mask on a Perkin-Elmer PE500 exposure tool with a setting for aperture 4 (radiation in the range of 240 - 280nm) and received an 8mJ/cm² exposure. The exposed wafer was subjected to a 90 second post exposure bake (PEB) at 90°C followed by a 90 second development in a xylene spray to provide 1 µm negative tone images having nearly straight wall profiles.

### Example 3:

A photoresist composition comprising 20 weight percent of a poly (4-t-butyloxycarbonyloxystyrene-co-4-hydroxy styrene) (PBOCST-PHOST) resin made in accordance with the disclosure of EP-A-366590, mentioned above 2 weight percent of a trifluoromethylsulfonyl oxybicyclo-[2.2.1]-hept-5-ene- 2,3-dicarboximide made in accordance with the procedure of Example 1 and referred to as MDT, and 78 weight percent propylene glycol methyl ether acetate was coated onto a silicon wafer and baked between 70 and 100°C (preferably between 70 and 90°C for 1 minute on a hot plate to give a 0.9 µm film. The coated wafer was exposed to a deep ultraviolet radiation through a chrome mask on a Perkin-Elmer PE500 exposure tool with a setting for aperture 4 and received a 15mJ/cm² exposure. The exposed wafer received a 90 second PEB at 90°C followed by a 60 second development in aqueous tetramethyl ammonium hydroxide (TMAH) which provided 1 µm positive images with nearly straight sidewalls. The Figure shows the resultant images Trifluoromethylsulfonyloxy-7-oxabicyclo-[2.2.1]-hept-5ene-2,3-dicarboximide, trifluoromethylsulfonyloxy succinimide (SDT) and bi-functional compounds containing two triflate groups per molecule such as N,N'-bistrifluoromethyl sulfonyloxyo(3- methyl-4,5-imido- cyclohex-3-enyl) succinimide were imaged in a similar manner.

### Example 4:

The sensitized resist materials of the present invention are also sensitive to electron beam exposure. The formulation of Example 2 (PBOCST and ODT) was baked for one minute at 100°C and was imaged with 2 µC/cm² dose of electron beam energy at 25 KeV followed by a 90 second PEB at 90°C and a 30 second development in a spray of xylene. High resolution negative images were produced.

### Example 5:

A formulation consisting of 2 weight percent of trifluoromethylsulfonyloxybicyclo[2.2.1]-hept-5-ene-2,3-dicarboximide(MDT), 5 weight -percent bis-Phenol A- di-t-butyl carbonate, 20 weight percent Novolak resin and 73 weight percent propylene glycol methyl ether acetate was coated onto a wafer to give a 1.2 µm film. The coated wafer was subjected to deep exposure in UV2 (240-260 nm) receiving a 10mJ/cm² dose followed by a 90 second PEB at 90°C and development in TMAH for 60 seconds which gave 0.5 and 1.0 µm lines in a positive mode.

### Example 6:

Another photoresist formulation consisting of 20 weight percent poly (4-t-butyloxycarbonyloxystyrene-co-4-hydroxy styrene) (PBOCST-PHOST) prepared in accordance with the method set forth in EP-A-366590, 0.75-1.0 weight percent of N-trifluoromethyl sulfonyloxyphthalimide (PDT) 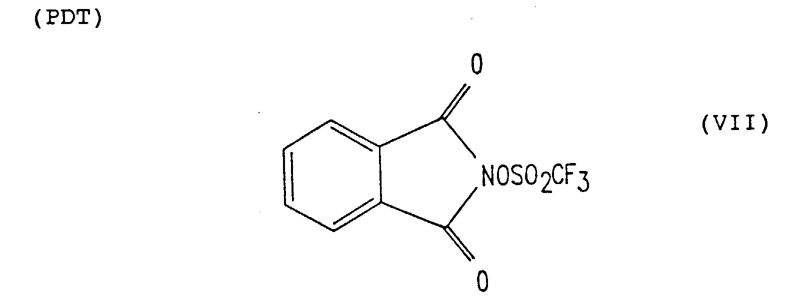 and the balance of propylene glycol methyl ether acetate was prepared and spun coated on a silicon wafer at 4500 rpm and baked at 90°C for 1 minute on a hot plate to give a film having a thickness from 0.9 to 1.1 µm. The coated wafer was exposed to deep UV radiation through a chrome mask on a Perkin Elmer PE500 exposure tool with a setting for aperture 4 and received a dose of 8-10 mJ/cm². The exposed wafer received a 90 second PEB at 90°C followed by a 60 second development in aqueous TMAH. 1 µm images were produced having nearly vertical sidewalls.

### Example 7:

Another positive photoresist formulation was prepared comprising 20 weight percent poly(4-t-butyl-oxycarbonyl oxystyrene-co-4-hydroxystyrene), (PBOCST-PHOST) 0.75 to 1.0 weight percent of N-trifluorosulfonyloxydiphenyl maleimide (DPMT) 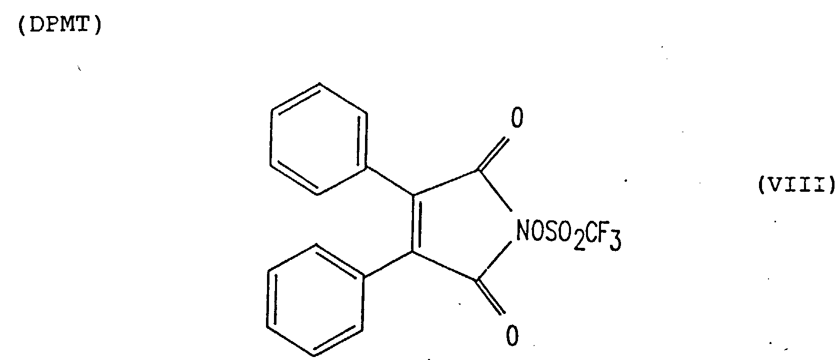 and the balance of propylene glycol methyl ether acetate was spun coated onto a silicon wafer at 4500 rpm and baked at 90°C for 1 minute on a hot plate to give a 0.9 to 1.1 µm film. The coated wafers were exposed to ultraviolet radiation through chrome masks on a Perkin Elmer PE 500 exposure tool on UV2, UV3, UV4 mode. The exposed wafers received a 90 second PEB at 90°C followed by a 60 second development in aqueous TMAH. The results were as follows:

| Mode | Wavelengths | Exposure Dose | Image Width |
|---|---|---|---|
| UV2 | 240-280nm | 6 mJ/ cm² | 1.0 µm |
| UV3 | 280-380nm | 24 mJ/ cm² | 1.25 µm |
| UV4 | 360-450nm | 30 mJ/ cm² | 2.00 µm |

All images had nearly vertical sidewalls.

### Example 8:

The resist composition of Example 7 (PBOCST-PHOST and DPMT) was prepared and spun on silicon wafers as described in that example. The coated wafers were then exposed to ultraviolet radiation on a CENSOR h-line stepper at 405nm receiving an exposure dose of 40mJ/cm². The exposed wafer received a 90 second PEB at 90°C followed by a 60 second development in aqueous TMAH and provided one µm positive images with nearly vertical sidewalls.

### Example 9:

Still another resist formulation was prepared comprising 20 weight percent poly(4-t-butyloxy-carbonyloxystyrene-co-4-hydroxy-styrene) (PBOCST-PHOST), 0.35 to 0.50 weight percent N-trifluorosulfonyloxyphthalimidyl ether and (ODPT) 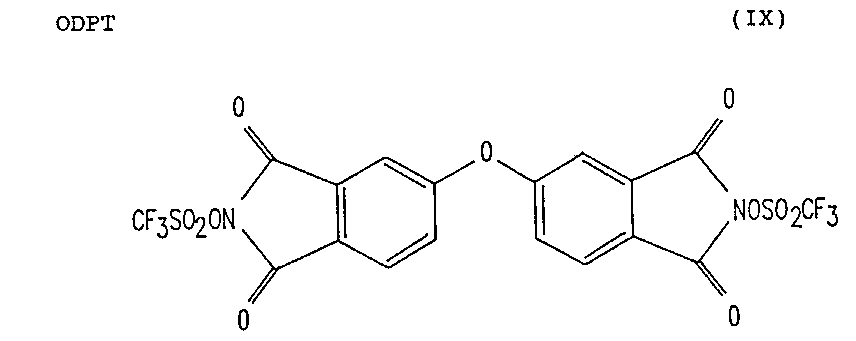 and the balance of propylene glycol methyl ether acetate was spun on a silicon wafer at 4500 rpm and baked for 1 minute on a 90°C hot plate to give a film of 0.9 - 1.1 µm thickness. The coated wafer was exposed to deep ultraviolet radiation through a chrome mask on a Perkin Elmer PE 500 exposure tool with a setting for aperture 4 and in UV2 with an average wavelength of 254 nm and received an 8-10 mJ/cm² exposure. The exposed wafer received a 90 second PEB at 90°C followed by a 60 second development in aqueous base. The resulting images were 1 µm in width with nearly vertical sidewalls.

### Example 10:

A negative photoresist formulation was prepared comprising 20 weight percent poly-t-butyloxycarbonyl-oxystyrene, 0.75 - 1.0 weight percent of bistrifluoromethylbis-N,N′-trifluoromethyl-sulfonyloxyphthalimidylmethane (6FPDT) 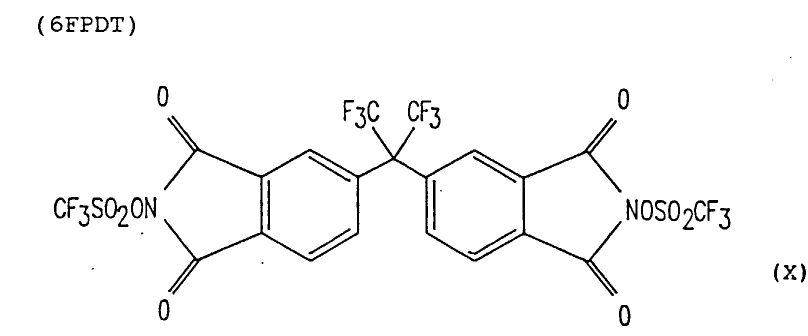 and the balance of propylene glycol methyl ether acetate. The formulation was spun coated onto a silicon wafer at 4500 rpm and baked at 90°C for 1 minute on a hot plate to give a 0.9 to 1.1 µm film. The coated wafer was exposed to deep ultraviolet radiation on a Perkin Elmer PE 500 exposure tool with a setting for aperture 4 in UV2 at an average wavelength of 254 nm and received an 8-10 mJ/cm² exposure dose. The exposed wafer was developed in xylene for 10 seconds providing 1 µm images with nearly vertical side walls.

### Example 11:

Another negative acting resist formulation was prepared comprising 20 weight percent poly-t-butyloxycarbonyloxy styrene (PBOCST), 0.75 - 1.0 weight percent N-trifluoromethylsulfonyloxydiphenyl maleimide, and the balance of propylene glycol methyl ether acetate. This composition was spun coated onto a silicon wafer at 4500 rpm and baked at 90°C for one minute on a hot plate to give a 0.9 - 1.1µm film. The coated wafer was exposed to ultraviolet radiation on a Perkin Elmer PE 500 exposure tool, UV3 mode and received a 100 mJ/cm² exposure dose. The exposed wafer received a 90 second PEB at 90°C followed by a 10 second development with xylene which produced 1 µm negative images with nearly vertical sidewalls.

### Example 12:

A monomer of N-trifluoromethylsulfonyloxy maleimide was prepared in the method as described by C.D. Beard et al, J. Org, Chem., 38, 3673(1973) and was polymerized with p-t-butyloxycarbonyloxystyrene in accordance with the method set forth in U.S. Patent No. 4,491,628 using azobisisobutyronitrile (AIBN) as an initiator.

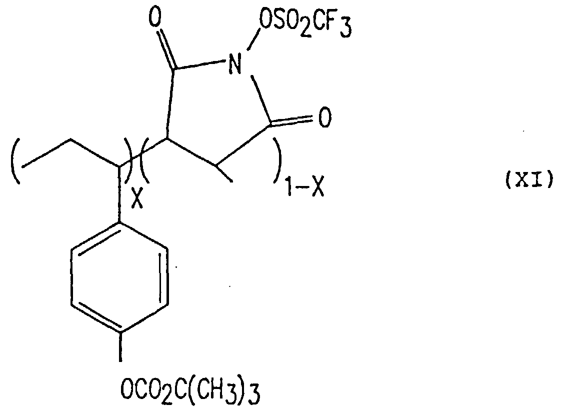

The resultant polymer poly(4-5-buryloxycarbonyloxy-styrene -co-N-trifluoromethane sulfonxyloxy maleimide) was spun coated on a silicon wafer and baked at 90°C for 1 minute on a hot plate. The coated wafer was exposed to deep ultraviolet radiation on a Perkin Elmer PE500 exposure to UV2 mode and received a 25 mJ/cm² exposure dose. The exposed wafer received a 90 second PEB at 90°C. Development in aqueous alkali produced 1.25 µm positive tone images.

### Example 13:

A poly(maleic anhydride-styrene) copolymer was reacted with hydroxylamine hydrochloride in pyridine to produce the corresponding N-hydroxylmaleimide-styrene copolymer. Thereafter this copolymer 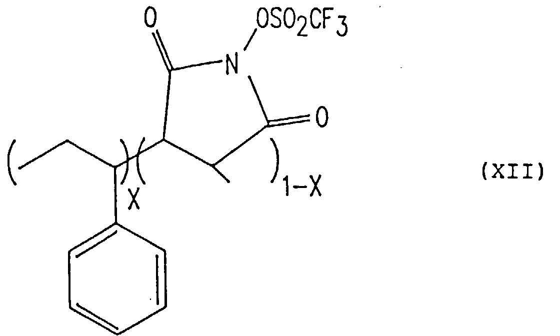 was reacted with triflic anhydride to produce poly- (N-trifluoromethylsulfonyloxymaleimide-co-styrene). A photo resist formulation was prepared comprising 20 weight per cent poly t-butyloxycarbonyloxystyrene (PBOCST), 8 weight percent poly-(N-trifluoromethyl-sulfonyloxymaleimide-co-styrene) and 72 weight percent propylene glycol methyl ether acetate. This composition was spun coated onto a silicon wafer and baked at 90°C for one minute on a hot plate to give a film 0.8 to 1.0 µm thick. The coated wafer was exposed to deep ultraviolet radiation through a chrome mask on a Perkin Elmer PE500 tool in the UV2 mode and received a 20-25 mJ/cm² exposure dose. The exposed wafer received a 90 second PEB at 90°C followed by development in anisole to provide good image transfer down to the substrate.

### Example 14:

A. An epoxide containing sensitizer was prepared by the oxidation of N-trifluorosulfonyloxybicyclo-[2.2.1]-hept -5-ene-2,3-dicarboximide (MDT) using metachloroperoxy benzoic acid in methylene chloride at 0°C. Purification was performed by chromotography (silica gel, hexane to ethyl acetate, in a ratio of 2 to 1). Proton and carbon NMR, IR, and UV spectra confirmed that the resultant material was N-trifluoromethylsulfonloxybicyclo- [2.2.1] -heptane-5,6-oxy-2,3- dicarboximide (EXMDT). 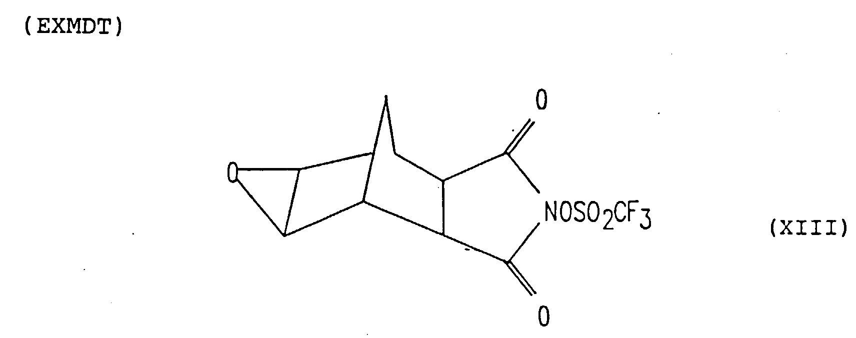
B. A positive tone resist formulation was prepared comprising 20 weight percent poly (4-t-butyloxycarbonyloxystyrene-co-4-hydroxystyrene) (PBOCST-PHOST), 2 weight percent of the epoxy sensitizer (EXMDT) prepared above, and the balance being propylene glycol methyl ether acetate. This resist formulation was spun on a silicon wafer at 3,000 RPM and dried on a hot plate at 90°C for 1 minute. The coated wafer was exposed to deep ultraviolet radiation using a Perkin-Elmer PE500 exposure tool with aperture setting 4 and an average wavelength of 254nm and the exposed wafers received a exposure dose of 6-8mJ/cm². The exposed wafers received a 90 second PEB at 90_C followed by development in aqueous base resulting in a pattern of 1 µm lines and spaces with nearly a vertical sidewalls.

It has surprisingly been found that sensitization of the sulfonyloxyimide (triflate) compositions of the present invention can be enhanced using sensitizers which are sufficiently transparent between 200 - 300 nm, the absorbance being less than preferable 0.8. These sensitizers are thought to undergo electron transfer mechanisms from the sensitizer to the triflate acceptor. Among the substituted benzene compounds, we have discovered that aromatic phenols such as hydroquinone, resorcinol, pyrogallol, bisphenol-A, 2,6-di-t-butyl-4-methylphenol, 3,3′,5,′-tetra-t-butylbisphenol A, and methylene bishydroquinone, 2,5-di-t-butylhydroquinone, have been found to potentiate bicyclo-[2.2.1]-hept-5-ene-2,3-dicarboximide triflates when used with a poly (4-t-butyloxycarbonyloxystyrene-co-4-hydroxystyrene) (PBCOST-PHOST) resist composition. It appears that after the photolytic cleavage of the triflate N-O bond the phenol compound enhances the formation of the triflic acid in the chemically amplified exposure process. The additional benefit of aromatic phenols is apparent in the increase of the sensitivity of the triflate to electron beam and x-ray exposure.

### Example 15:

A resist formulation comprising: 20 weight percent poly(4-t-butyloxycarbonyloxystyrene-co-4-hydroxystyrene), (BCOS-PHOS), 2 weight percent N-trifluoromethyl sulfonyloxybicyclo-[2.2.1]-hept-5-ene-2,3-dicarboximide (MDT), and 2 weight percent hydroquinone showed an increase in sensitivity to x-ray exposures of at least two times and to electron beam exposure of 1.5 times. Table 1 shows the comparison of photoresists with and without additional the addition of such additives.

**Table 1:**

| Resist Polymer | Additive (% loading) | Exposure Medium | Exposure Dose |
|---|---|---|---|
| PBOCST-PHOST | Control (no additive) | X-Ray | 70-90 mJ/cm² |
| PBOCST-PHOST | Control (no additive) | UV (254 nm) | 4-6 mJ/cm² |
| PBOCST-PHOST | Control (no additive) | e-beam | 5 µC/cm² |
| PBOCST-PHOST | Hydroquinone (1 - 3%) | X-Ray | 15-25 mJ/cm² |
| PBOCST-PHOST | Hydroquinone (1 - 3%) | UV (254 nm) | 2-3 mJ/cm² |
| PBOCST-PHOST | Hydroquinone (1 - 3%) | e-beam | 2.5 µC/cm² |
| PBOCST | Control (no additive) | UV | 3 mJ/cm² |
| PBOCST | Hydroquinone (1 - 3%) | UV | 0.5 mJ/cm² |
| PBOCST | Pyrogallol (1 - 3%) | UV | 1 mJ/cm² |
| PBOCST | Benzophenone (1 - 3%) | UV | no image |
| PBOCST | Novolak resin | UV | 2.5 mJ/cm² |

### Example 16:

A resist formulation comprising 20 weight percent poly (4-t-butyloxycarbonyloxystyrene) (PBOCST), 2 weight percent N-pentafluorobenzenesulfonyloxy-bicyclo-[2,21]-hept -5-ene-2,3-dicarboximide, 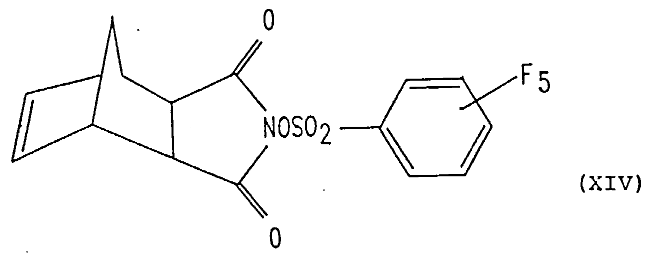 2 weight percent hydroquinone, and 71 weight percent propylene glycol methyl ether acetate was prepared as was a like resist without hydroquinone. Upon imaging and development to form negative images in UV2 it was noted that 1 µm images were resolved at 50 mJ/cm² with the hydroquinone containing resist while the non-hydroquinone containing resist required a 100 mJ/cm² dose.

### Example 17:

A base developable negative resist may be prepared wherein an alkali soluble base resin such as p-hydroxystyrene is combined with a crosslinking agent such as for example an alkoxylated melamine formaldehyde or urea formaldehyde resin and the triflate sensitizer of the present invention. A composition comprising approximately 15% p-hydroxystyrene, 5% alkoxylated urea formaldehyde, 2% MDT and 78% propylene glycol methyl ether acetate will produce fine negative images in UV, e-beam and x-ray radiation due to the cleavage of the alkoxy group from the urea formaldehyde backbone and subsequent crosslinking with the p-hydroxystyrene in the exposed areas.

While the preferred embodiments of the invention have been described by the above, it is understood that the invention is not limited to the precise compositions herein disclosed and that rights are reserved to all changes and modifications coming within the scope of the invention as defined in the following claims.

## Claims

1. A resist for use in photon, electron beam and x-ray exposure devices comprising
(a) a polymeric or copolymeric composition, the solubility of said composition being dependent upon the presence of acid removable protecting groups, and
(b) a non metallic sulfonic acid precursor which generates a strong acid upon exposure to radiation.
characterized in that said sulfonic acid precursor is a sulfonyloxyimide having the structural formula 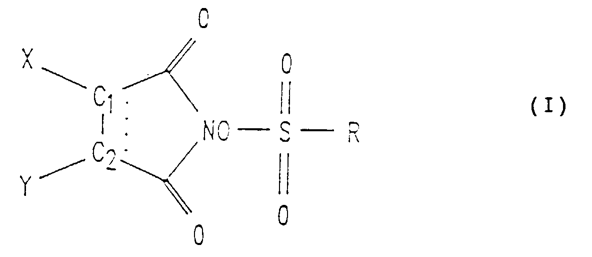 where C₁ and C₂ may form a single or double band wherein R is selected from -CF₃,-CF₂CF₃, -CF₂CF₂H, -(CF₂)-Zₙ where n=1 to 4, where Z is H, alkyl or aryl, 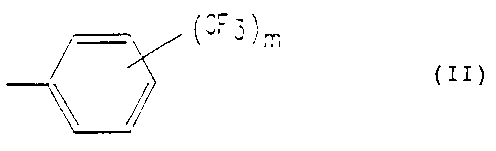 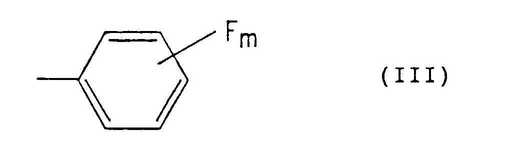 where m is from 1 to 5, and where X and Y (1) form a cyclic or polycyclic ring which may contain one or more hetero atoms, (2) form a fused aromatic ring, (3) may be independently H, alkyl or aryl, (4) may be attached to another sulfonyloxyimide containing residue, or (5) may be attached to a polymeric chain or backbone.

2. The resist according to claim 1 wherein the sulfonic acid precursor is present in an amount from 1 - 20% by weight of the composition.

3. The resist according to claim 2 wherein the sulfonic acid precursor is present in an amount from 5 - 10% by weight of the composition.

4. The resist according to claim 1 wherein said composition comprises a soluble polymer and a solubility inhibiting compound.

5. The resist according to claim 4 wherein the molecular solubility inhibiting compound is bisphenol A di-t-butyl carbonate.

6. The resist according to claim 1 wherein a sufficient amount of substituted benzene compound is provided to enhance the formation of the strong acid.

7. The resist according to claim 6 wherein the substituted benzene compound is present in an amount from 1 to 3% by weight of the composition.

8. The resist according to claim 6 wherein the substituted benzene compound is selected from the group consisting of hydroquinone, resorcinol, pyrogallol, p-bisphenol A, 2,6-di-t-butyl-4-methylphenol, 3,3',5,5'-tetra-t-butylbisphenol A, and methylene bishydroquinone.

9. The resist in accordance with claim 1 wherein the sulfonic acid precursor is selected from the group consisting of trifluoromethylsulfonyloxy-7-oxa-bicyclo [2.2.1] hept-5-ene-2,3-dicarboximide and trifluoromethylsulfonyloxy-bicyclo-[2.2.2]-hept-5-ene -2,3 dicarboximide.

10. The resist according to claim 1 which has an absorbance at 200 - 300 nm below 0.8.

## Patentansprüche

1. Resist zur Verwendung bei Photonen-, Elektronenstrahl- und Röntgenstrahl-Belichtungseinrichtungen, das beinhaltet
(a) eine polymere oder copolymere Zusammensetzung, wobei die Löslichkeit der Zusammensetzung von der Anwesenheit von durch Säure entfernbaren Schutzgruppen abhängig ist, und
(b) ein nichtmetallisches Sulfonsäurevorprodukt, das bei Belichtung mit Strahlung eine starke Säure erzeugt,
dadurch gekennzeichnet, daß das Sulfonsäurevorprodukt ein Sulfonyloxyimid mit der Strukturformel 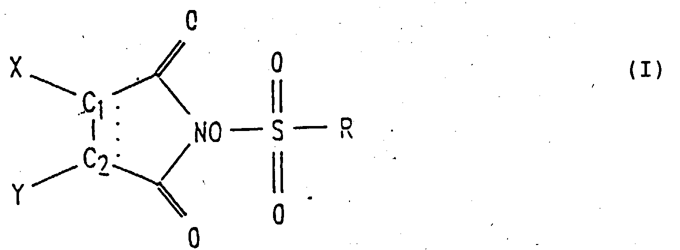 ist, wobei C₁ und C₂ eine Einzel- oder Dippelbindung bilden können, wobei R aus -CF₃, -CF₂CF₃, -CF₂CF₂H, -(CF₂)-Zₙ ausgewählt ist, wobei n = 1 bis 4, wobei Z H, Alkyl oder Aryl, 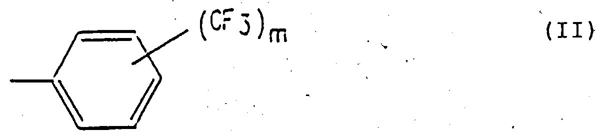 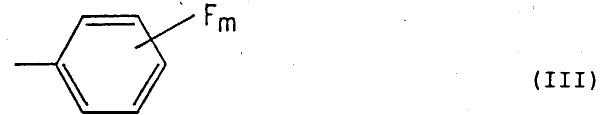 ist, wobei m 1 bis 5 ist und wobei X und Y (1) einen cyclischen oder polycyclischen Ring bilden, der ein oder mehrere Heteroatome enthalten kann, (2) einen verschmolzenen aromatischen Ring bilden, (3) unabhängig voneinander H, Alkyl oder Aryl sein können, (4) an einen ein weiteres Sulfonyloxyimid enthaltenden Rest angebunden sein können oder (5) an eine polymere Kette oder ein polymeres Hauptgerüst angebunden sein können.

2. Resist gemäß Anspruch 1, wobei das Sulfonsäurevorprodukt in einer Menge von 1 Gewichtsprozent bis 20 Gewichtsprozent der Zusammensetzung vorliegt.

3. Resist gemäß Anspruch 2, wobei das Sulfonsäurevorprodukt in einer Menge von 5 Gewichtsprozent bis 10 Gewichtsprozent der Zusammensetzung vorliegt.

4. Resist gemäß Anspruch 1, wobei die Zusammensetzung ein lösliches Polymer und eine löslichkeitsverhindernde Verbindung beinhaltet.

5. Resist gemäß Anspruch 4, wobei die löslichkeitsverhindernde molekulare Verbindung Bisphenol-A-di-t-butylcarbonat ist.

6. Resist gemäß Anspruch 1, wobei eine ausreichende Menge an einer substituierten Benzenverbindung bereitgestellt wird, um die Bildung der starken Säure zu steigern.

7. Resist gemäß Anspruch 6, wobei die substituierte Benzenverbindung in einer Menge von 1 Gewichtsprozent bis 3 Gewichtsprozent der Zusammensetzung vorliegt.

8. Resist gemäß Anspruch 6, wobei die substituierte Benzenverbindung aus der Gruppe ausgewählt ist, die aus Hydrochinon, Resorcinol, Pyrogallol, p-Bisphenol A, 2,6-Di-t-butyl-4-methylphenol, 3,3',5,5'-Tetra-t-butylbisphenol A und Methylenbishydrochinon besteht.

9. Resist gemäß Anspruch 1, wobei das Sulfonsäurevorprodukt aus der Gruppe ausgewählt ist, die aus Trifluormethylsulfonyloxy-7-oxabicyclo[2.2.1]hept-5-en-2,3-dicarboximid und Trifluormethylsulfonyloxy-bicyclo-[2.2.2]-hept-5-en-2,3-dicarboximid besteht.

10. Resist gemäß Anspruch 1, das bei 200 nm bis 300 nm ein spektrales Absorptionsmaß von unter 0,8 besitzt.

## Revendications

1. Résist destiné à être utilisé dans des systèmes de sensibilisation à photons, faisceau d'électrons et rayons X, comprenant :
(a) une compositon polymère ou copolymère, la solubilité de ladite composition dépendant de la présence de groupes protecteurs éliminables à l'acide, et
(b) un précurseur d'acide sulfonique non-métallique qui génère un acide fort lorqu'il est soumis à rayonnement ;
caractérisé en ce que ledit précurseur d'acide sulfonique est un sulfonyloxyimide ayant la formule de constitution 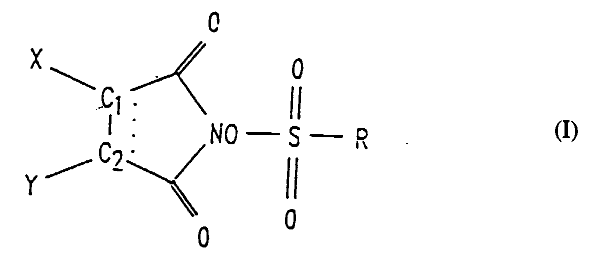 où C₁ et C₂ peuvent former une simple ou double bande, où R est choisi dans le groupe composé de -CF₃, -CF₂CF₃, -CF₂CF₂H, -(CF₂)-Zₙ où n est compris entre 1 et 4, où Z est H, alkyle ou aryle, 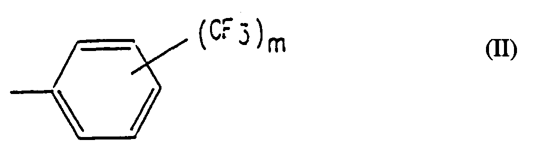 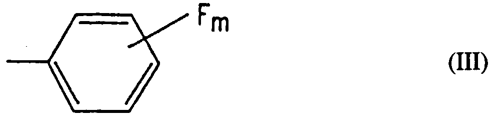 où m est compris entre 1 et 5, et où X et Y (1) forment un anneau cyclique ou polycyclique qui peut contenir un ou plusieurs hétéroatomes, (2) forment une combinaison cyclique aromatique condensée, (3) peuvent être indépendamment H, alkyle, ou aryle, (4) peuvent être combinés à un autre résidu contenant du sulfonyloxyimide, ou (5) peuvent être combinés à une chaîne ou une ossature polymère.

2. Résist selon la revendication 1, où le précurseur d'acide sulfonique est présent dans une quantité comprise entre 1 et 20% en pourcentage de poids de la composition.

3. Résist selon la revendication 2, où le précurseur d'acide sulfonique est présent dans une quantité comprise entre 5 et 10% en pourcentage de poids de la composition.

4. Résist selon la revendication 1, où ladite composition est composée d'un polymère soluble et d'un composé inhibiteur de solubilité.

5. Résist selon la revendication 4, où le composé inhibiteur de solubilité est du di-t-butyl-carbonate de bisphénol A.

6. Résist selon la revendication 1, où une quantité suffisante de composé benzénique substitué est prévue pour stimuler la formation de l'acide fort.

7. Résist selon la revendication 6, où le composé benzénique substitué est présent dans une quantité comprise entre 1 et 3% en pourcentage de poids de la composition.

8. Résist selon la revendication 6, où le composé benzénique substitué est choisi dans le groupe composé de l'hydroquinone, du résorcinol, du pyrogallol, du p-bisphénol A, du 2,6-di-t-butyl4-méthylphénol, du 3,3',5,5'-tétra-t-butylbisphénol A et de la bishydroquinone de méthylène.

9. Résist selon la revendication 1, où le précurseur d'acide sulfonique est choisi dans le groupe composé du trifluorométhylsulfonyloxy-7-oxa-bicyclo-[2.2.1]-hept-5ène-2,3-dicarboximide et du trifluorométhylsulfonyloxy-bicyclo-[2.2.2]-hept-5-ène-2,3-dicarboximide.

10. Résist selon la revendication 1, dont l'absorbance entre 200 et 300 nm est inférieure à 0,8.
